# EUROPEAN PATENT APPLICATION

(11) **EP 2 793 260 A1**
(43) Date of publication of application: **22.10.2014**
(21) Application number: 12857172.6
(22) Date of filing: 07.11.2012
(51) Int. Cl.: H01L 23/473, H01L 25/07, H01L 25/18

(54) **SEMICONDUCTOR DEVICE**

(30) Priority: 12.12.2011 JP 2011271575
(71) Applicant: Kabushiki Kaisha Toyota Jidoshokki, Kariya-shi, Aichi 448-8671 (JP)
(72) Inventor: IWATA, Yoshitaka, Kariya-shi Aichi 448-8671 (JP); MORI, Shogo, Kariya-shi Aichi 448-8671 (JP); KAMIYAMA, Daizo, Kariya-shi Aichi 448-8671 (JP)
(74) Representative: Winter, Brandl, Fürniss, Hübner, Röss, Kaiser, Polte - Partnerschaft mbB
(86) International application number: PCT/JP2012/078895
(87) International publication number: WO 2013/088864

(57) **Abstract**

A semiconductor device includes a cooling portion, which is made of ceramic or resin and includes a mounting surface, a metal circuit board, which is mounted on the mounting surface of the cooling portion and includes an element mounting surface, and a semiconductor element mounted on the element mounting surface of the circuit board. At least a part of the circuit board, which corresponds to the element mounting surface, is covered with resin with respect to the cooling portion.

## Description

### TECHNICAL FIELD

The present invention relates to a semiconductor device including a cooling portion that is made of ceramic or resin.

### BACKGROUND ART

Conventionally, a semiconductor device (semiconductor module) has been known that is structured as a module formed by joining a heat dissipation device (heat sink) to a circuit board (direct brazed aluminum (DBA) board). The circuit board is formed by joining metal boards such as pure aluminum boards to both of the front and back sides of a ceramic substrate (insulated substrate), which is, for example, made of aluminum nitride. For example, refer to Patent Document 1. In this type of the semiconductor device, the heat generated by a semiconductor element is emitted by the heat dissipation device.

### PRIOR ART DOCUMENT

### Patent Document

Patent Document 1: Japanese Laid-Open Patent Publication No. 2006-294699

### SUMMARY OF THE INVENTION

### Problems that the Invention is to Solve

When a metal (aluminum) heat dissipation device is employed as in the case of the semiconductor device of Patent Document 1, a difference in linear expansion coefficients of the circuit board and the heat dissipation device may cause a thermal stress. This may separate the semiconductor element from the circuit board at the joined portion, or the circuit board from the heat dissipation device at the joined portion. Accordingly, in the semiconductor device of Patent Document 1, a stress relaxation member, which relaxes the thermal stress, is located between the circuit board and the heat dissipation device to achieve a desired reliability at each joined portion.

An objective of the present invention is to provide a semiconductor device that can improve the reliability of the joined portion between the semiconductor device and the circuit board, and the joined portion between the circuit board and the cooling portion.

### Means for Solving the Problems

To achieve the above described object, a semiconductor device including a cooling portion, a metal circuit board, and a semiconductor element is provided. The cooling portion is made of ceramic or resin and includes a mounting surface. The metal circuit board is mounted on the mounting surface of the cooling portion and includes an element mounting surface. The semiconductor element is mounted on the element mounting surface of the circuit board. At least a part of the circuit board that corresponds to the element mounting surface is covered with resin with respect to the cooling portion.

According to the above configuration, the cooling portion made of ceramic or resin is employed, and at least a part of the circuit board corresponding to the element mounting surface is covered with resin with respect to the cooling portion to improve the reliability of the joined portion between the semiconductor element and the circuit board and the joined portion between the circuit board and the cooling portion. Since the resin limits thermal deformation, the reliability of each joined portion is improved.

### BRIEF DESCRIPTION OF THE DRAWINGS

Fig. 1 is a front view illustrating a semiconductor device according to one embodiment of the present invention;
Fig. 2 is a front view illustrating a semiconductor device according to another embodiment; and
Fig. 3 is a front view illustrating a semiconductor device according to another embodiment.

### MODES FOR CARRYING OUT THE INVENTION

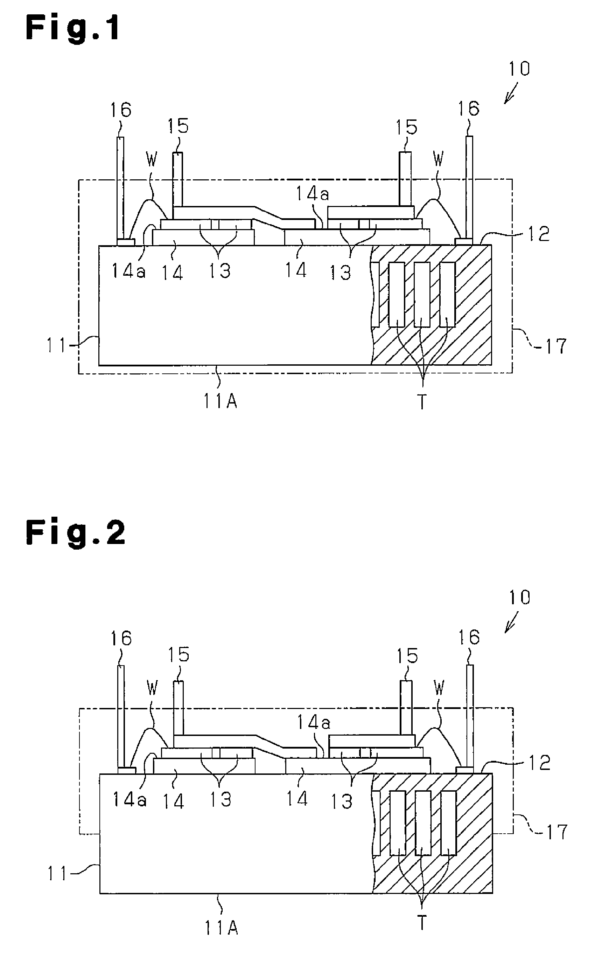

Hereinafter, a semiconductor device according to one embodiment of the present invention will be described with reference to Fig. 1.

As shown in Fig. 1, a semiconductor device 10 of the present embodiment includes a heat dissipation device 11, which serves as a cooling portion. The heat dissipation device 11 includes a base body 11A made of ceramic, and a plurality of coolant channels T, which are formed in the base body 11A. Coolant flows through the coolant channels T into the base body 11A. Each of metal circuit boards 14, which serves as a circuit board, is joined to a mounting surface (surface for mounting an object to be cooled) 12 of the heat dissipation device 11. Each of semiconductor elements 13, which serves as an electronic part, is mounted on a corresponding one of element mounting surfaces 14a of the metal circuit boards 14. That is, each metal circuit board 14 is directly located between the heat dissipation device 11 and the corresponding semiconductor element 13. The metal circuit boards 14 serve as wiring layers (electrodes) and joining layers, and are made of pure aluminum (for example, 1000 series aluminum as aluminum for industrial use) or copper. As the semiconductor elements 13, insulated gate bipolar transistors (IGBT) and diodes are used, for example. Soldering is used for joining the metal circuit boards 14 with the semiconductor elements 13. Brazing is used for joining the metal circuit boards 14 with the heat dissipation device 11. A supply tube for supplying a coolant into the heat dissipation device 11, and a discharge tube for discharging the coolant, which has flowed through the heat dissipation device 11, outward are also connected to the heat dissipation device 11. The supply tube and the discharge tube are not illustrated.

In the semiconductor device 10, each of metal conductive boards 15 used as an external connection terminal is joined to a terminal of the corresponding one of the semiconductor elements 13. In the semiconductor device 10, each of metal connecting pins 16 used as an external connection terminal is joined to the mounting surface 12 of the heat dissipation device 11. The semiconductor elements 13 and the connecting pins 16 are electrically connected to each other through wires W, or wiring materials. The conductive boards 15 and the connecting pins 16 are made of copper. Soldering or brazing is used for the joints between the semiconductor elements 13 and the conductive boards 15 and the joints between the heat dissipation device 11 and the connecting pins 16.

For example, aluminum oxide, silicon nitride, silicon carbide, aluminum nitride, and alumina zirconium are used as a ceramic material that forms the heat dissipation device 11. When employing a water cooled system as a cooling system of the heat dissipation device 11, it is preferable that the ceramic material have high water resistance. When the ceramic material is considered from a viewpoint of the stress relaxation by generation of heat of the semiconductor elements 13, it is preferable that the ceramic material have a linear expansion coefficient that is closer to the linear expansion coefficient of the semiconductor elements 13. Accordingly, each metal circuit board 14 is directly located between the heat dissipation device 11 and the corresponding semiconductor element 13 with the liner expansion coefficients closer to each other. That is, each metal circuit board 14 directly contacts the heat dissipation device 11 and the corresponding semiconductor element 13. The linear expansion coefficients of the heat dissipation device 11 and the semiconductor elements 13 are less than the linear expansion coefficient of the metal circuit boards 14.

The semiconductor device 10 according to the present embodiment is covered with resin 17, that is, molded in the resin 17, to cover the entire heat dissipation device 11 and various types of parts mounted on the mounting surface 12 of the heat dissipation device 11. The entire heat dissipation device 11 refers to an entire surface including a surface (bottom surface) opposite to the mounting surface 12 and lateral sides as well as the mounting surface 12. The entire semiconductor elements 13 and the entire metal circuit boards 14 in the various types of the parts mounted on the mounting surface 12 are covered with the resin 17. That is, the element mounting surfaces 14a of the metal circuit boards 14, on which the semiconductor element 13 are mounted, are also covered with the resin 17. Parts to be connected to peripheral portions in the various types of the parts mounted on the mounting surface 12 are partially covered with the resin 17. Remaining portions of the parts are exposed outside of the resin 17. The parts to be connected to the peripheral portions include the conductive boards 15, the connecting pins 16, and the above supply tube and the discharge tube. The resin 17 for molding is made of epoxy resin. The molding by the resin 17 is performed after the various types of the parts such as the semiconductor elements 13, the metal circuit boards 14, the conductive boards 15, and the connecting pins 16 are joined and the semiconductor elements 13 and the connecting pins 16 are bonded by the wires W. The molding by the resin 17 is performed at a temperature lower than the temperature at which the soldering of the semiconductor elements 13 and the metal circuit boards 14 or the brazing of the heat dissipation device 11 and the metal circuit boards 14 is performed.

Hereinafter, an operation of the semiconductor device 10 of the present embodiment will be described.

The coolant supplied from the coolant supply source flows through the supply tube connected to the heat dissipation device 11 into each coolant channel T. The coolant, which has flowed into the coolant channels T, flows in the same direction. When the coolant flows through the coolant channels T as described above, the heat of the semiconductor elements 13 transmitted through the metal circuit boards 14 to the heat dissipation device 11 is emitted through the coolant, which flows through the coolant channels T. The coolant after the heat exchange, which has flowed through the coolant channels T, is discharged outside through the discharge tube connected to the heat dissipation device 11. Since the heat dissipation device 11 of the present embodiment is made of ceramic, the heat dissipation device 11 has an insulating function as well as the cooling function.

Accordingly, the present embodiment has the following advantages.
(1) The semiconductor device 10 of the present embodiment employs the heat dissipation device 11 made of ceramic, which is formed by integrating the insulating portion and the coolant channels. The semiconductor device 10, which includes the heat dissipation device 11, is covered with the resin 17, that is, molded in the resin 17. The heat dissipation device 11 made of ceramic itself has both the insulating function and the cooling function. This simplifies the configuration of the semiconductor device 10 more than in the case where a DBA board (substrate formed by joining metal boards to both of the front and back sides of the insulating substrate made of ceramic) is joined to a metal heat dissipation device as in the conventional case. That is, in the semiconductor device 10 of the present embodiment, the metal circuit boards 14, on which the semiconductor elements 13 are mounted, are directly joined to the heat dissipation device 11. This simplifies the configuration of the semiconductor device 10.
(2) The heat dissipation device 11 made of ceramic is employed. Accordingly, the semiconductor device 10 inherently includes a structure in which heat stress is not easily generated. The semiconductor device 10 is molded in the resin 17. This improves the reliability of the joined portions between the semiconductor elements 13 and the metal circuit boards 14 and the joined portions between the metal circuit boards 14 and the heat dissipation device 11. That is, a thermal deformation is limited according to the molded resin 17. This improves the reliability of each joined portion. According to the semiconductor device 10 of the present embodiment, the stress relaxation member, which is located between the circuit board and the heat dissipation device in the conventional semiconductor device, is omitted by employing the heat dissipation device 11 made of ceramic.
(3) Each metal circuit board 14 is directly located between the heat dissipation device 11 made of ceramic and the corresponding semiconductor element 13, which has a linear expansion coefficient less than the linear expansion coefficient of the metal circuit board 14. This limits the generation of the thermal stress. Accordingly, the reliability of each joined portion is further improved.
(4) The entire semiconductor elements 13 and the entire metal circuit boards 14 are covered with the resin 17. This eliminates the necessity for a structure for fixing these parts to the heat dissipation device 11, for example, a fixation structure for pressing and holding the semiconductor elements 13 and the metal circuit boards 14 toward the heat dissipation device 11. This further simplifies the configuration of the semiconductor device 10.
(5) The entire heat dissipation device 11 is covered with the resin 17 as well as the semiconductor elements 13 and the metal circuit boards 14. This facilitates the handling of the semiconductor device 10. When the heat dissipation device 11 is made of ceramic, the heat dissipation device 11 is inferior in strength to the metal heat dissipation device 11. However, since the protection performance of the heat dissipation device 11 is improved by covering the entire heat dissipation device 11 with the resin 17, the handling of the semiconductor device 10 is facilitated, and the long-term excellent heat dissipation performance is achieved. In particular, in the attachment process such as the case of mounting the semiconductor device 10 on a vehicle, the handling is facilitated to improve the operability. This is advantageous.
(6) The entire heat dissipation device 11 is covered with the resin 17. This improves the sealing property of the heat dissipation device 11. This improves the heat dissipation performance.
(7) The semiconductor device 10 is molded in the resin 17 so that the reliability of each joined portion is improved. This maintains the performance (reliability) of the semiconductor device 10 over an extended period of time. That is, the degradation of the semiconductor device 10 is limited.
(8) Since the difference in the linear expansion coefficients of the resin 17 and the ceramic is small, the desired reliability of the joined portion between the resin 17 and the heat dissipation device 11 made of ceramic is also obtained. That is, the resin 17 is not easily separated from the heat dissipation device 11 at the joined portion. This maintains the above advantages (2), (4), and (5) to (7), which can be generated by the molded resin 17, over an extended period of time.
(9) The heat dissipation device 11 made of ceramic is employed. This reduces the size of the semiconductor device 10 as well as simplifying the configuration of the semiconductor device 10. Accordingly, when mounting the semiconductor device 10 on a vehicle, the space occupied by the semiconductor device 10 is reduced. This expands the flexibility of design.

The present embodiment may be modified as follows.

As shown in Fig. 2, the region to be molded in the resin 17 may be reduced to a part of the lateral sides of the heat dissipation device 11 in place of the configuration in which the entire heat dissipation device 11 is covered with the resin 17. That is, the surface opposite to the mounting surface 12 of the heat dissipation device 11 is exposed without being covered with the resin 17. The entire mounting surface 12 and a part of the lateral sides of the heat dissipation device 11 are molded with the resin 17. This allows a heating body to be cooled on the opposite surface as well. The amount of the resin 17 is reduced. This contributes to the reduction of the manufacturing cost of the semiconductor device 10. The amount of the resin 17 is reduced. This relaxes the stress received from the molded resin 17.

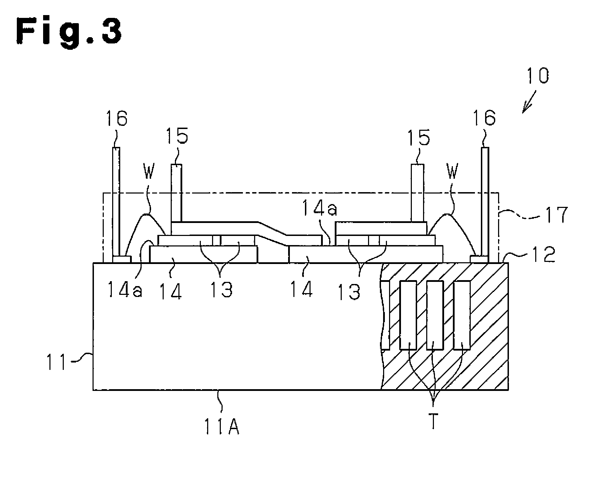

As shown in Fig. 3, the region to be molded in the resin 17 may be reduced to only the mounting surface 12 of the heat dissipation device 11 in place of the configuration in which the entire heat dissipation device 11 is covered with the resin 17. Only the mounting surface 12 of the heat dissipation device 11 is molded in the resin 17. That is, the entire surface opposite to the mounting surface 12 of the heat dissipation device 11 is exposed without being covered with the resin 17. The entire lateral sides of the heat dissipation device 11 are also exposed. According to this, the same advantage as that of another embodiment described above with reference to Fig. 2 is obtained, and the amount of the resin 17 is further reduced.

In the embodiments described with reference to Figs. 2 and 3, when joining the heating body to the opposite surface of the heat dissipation device 11, the entire heat dissipation device 11 including the heating body may be molded in the resin 17.

The heat dissipation device 11 may be made of resin in place of ceramic.

The configurations of the various types of the parts to be mounted on the heat dissipation device 11 may be changed.

The coolant channel T in the heat dissipation device 11 may be a linear channel as viewed from above, or a wavy channel or a zigzag channel as viewed from above. In the wavy or zigzag channel, the flow of the coolant is more turbulent than the flow in the linear channel. This improves the cooling performance according to the effect of the turbulent flow.

The coolant, which flows through the heat dissipation device 11, may be a liquid coolant or a gas coolant.

## Claims

1. A semiconductor device, comprising:
a cooling portion, which is made of ceramic or resin and includes a mounting surface;
a metal circuit board, which is mounted on the mounting surface of the cooling portion and includes an element mounting surface; and
a semiconductor element mounted on the element mounting surface of the circuit board, wherein at least a part of the circuit board that corresponds to the element mounting surface is covered with resin with respect to the cooling portion.

2. The semiconductor device according to claim 1, wherein the cooling portion is made of ceramic.

3. The semiconductor device according to claim 2, wherein a linear expansion coefficient of each of the semiconductor element and the cooling portion is less than a linear expansion coefficient of the circuit board, and the circuit board is directly located between the semiconductor element and the cooling portion.

4. The semiconductor device according to any one of claims 1 to 3, wherein the semiconductor element, the circuit board, and the cooling portion are covered with the resin.

5. The semiconductor device according to any one of claims 1 to 3, wherein
the entire semiconductor element and the entire circuit board are covered with the resin,
the cooling portion includes an opposite surface, which is positioned opposite to the mounting surface, and
the cooling portion is covered with the resin such that at least the entire opposite surface is exposed.

6. The semiconductor device according to claim 5, wherein
the cooling portion includes a lateral side, and
the entire mounting surface of the cooling portion and a part of the lateral side are covered with the resin.

7. The semiconductor device according to claim 5, wherein
the cooling portion includes a lateral side, and
the mounting surface of the cooling portion is covered with the resin such that the entire lateral side of the cooling portion and the entire opposite surface are exposed.
